# EUROPEAN PATENT APPLICATION

(11) **EP 1 076 368 A2**
(43) Date of publication of application: **14.02.2001**
(21) Application number: 00202716.7
(22) Date of filing: 31.07.2000
(51) Int. Cl.: H01L 51/20

(54) **A surface-emitting organic light-emitting diode**

(30) Priority: 11.08.1999 US 371814
(71) Applicant: EASTMAN KODAK COMPANY, Rochester, New York 14650 (US)
(72) Inventor: Hung, Liang-Sun, c/o Eastman Kodak Company, Rochester, New York 14650-2201 (US); Madathil, Joseph Kuru, c/o Eastman Kodak Company, Rochester, New York 14650-2201 (US)
(74) Representative: Lewandowsky, Klaus, Dipl.-Ing.

(57) **Abstract**

An transparent cathode includes an electron injector, a metal layer over the injector, and transparent layer deposited over the metal layer and having a refractive index equal to or greater than 1.2.

## Description

### FIELD OF THE INVENTION

The present invention relates to transparent electron-injecting electrodes which are particularly, effective for use with surface-emitting organic light-emitting diodes.

### BACKGROUND OF THE INVENTION

Conventional organic light-emitting diodes (OLED) has a transparent substrate, typically indium-tin-oxide (ITO) glass, through which the light is emitted, and the surface electrode such as MgAg is normally opaque. Surface-emitting OLED structure is of considerable interest in many display applications where high-resolution is desirable. Such a surface-emitting structure is definitely required for an active-matrix OLED display fabricated on a Si substrate, which has an important advantage of having on-chip data and scan drivers, allowing for ultra-high pixel resolution (<10 microns). Despite such importance, there was only limited success in fabricating a suitable transparent top electrode.

G. Gu and others reported an OLED structure with a transparent top electrode consisting of a thin MgAg layer and a thicker overlying ITO film. See "Transparent organic light emitting devices" by G. Gu, V. Bulovic, P. E. Burrows, S. R. Forrest, and M. E. Thompson in Appl. Phys. Lett. 68, 2606 (1996). When ITO was deposited using a conventional sputtering process, the resulting OLED was often leaky, indicative of inter-electrode shorts. Furthermore, the forward device current was substantially lower than that of a conventional device with a thermally evaporated thick MgAg cathode. A low sputtering power of 5 W for ITO was found necessary to produce functional OLEDs without excessive shorts. However, the sputtering rate (about 0.3 nm/min) was exceedingly slow because of the low sputtering power used.

More recently, Parthasarathy and others, and Hung and others. introduced a new transparent top electrode structure employing a thin film of copper phthalocyanine (CuPc) instead of MgAg, overlaid by a sputter-deposited ITO film. See "A metal-free cathode for organic semiconductor devices" by G. Parthasarathy, P. E. Burrows, V. Khalfin, V. G. Kozlov, and S. R. Forrest, in Appl. Phys. Lett. 72, 2138 (1998) and see " Interface engineering in preparation of organic surface-emitting diodes" by L. S. Hung and C. W. Tang in Appl. Phys. Left. 74, 3209 (1999). The CuPc apparently acts as a buffer in reducing the shorting problem caused by the ITO sputtering process. However, the CuPc layer forms an electron-injection barrier with the Alq layer, resulting in increased electron-hole recombination in the non-emissive CuPc layer, and thus a substantial reduction in EL efficiency. Incorporation of Li at the CuPc/Alq interface was necessary to reduce the injection barrier at the interface and recover the device efficiency.

Since OLEDs are extremely sensitive to radiation, the use of a sputter-deposited ITO film to form a transparent top electrode not only increases the complexity of electrode preparation, but also introduces substantial radiation damage to OLEDs, thus resulting in device shorts and severe degradation of device performance. The use of a buffer layer is not sufficient to completely resolve the problems, and makes the process more difficult for manufactory.

### SUMMARY OF THE INVENTION

It is the object of this invention to provide a multilayer structure, which is highly transmissive and acts as an effective electron-injecting electrode in OLEDs.

This object is achieved by a transparent cathode comprising:
(a) an electron injector;
(b) a metal layer over the injector; and
(c) a transparent layer deposited over the metal layer and having a refractive index equal to or greater than 1.2.

The disclosed structure in this invention can be prepared by conventional thermal evaporation in one pump-down, so that the process is significantly simplified and no radiation damage is introduced during deposition. The efficient metal-organic contact and the highly conductive metal layer ensure device operation at low voltages. As a result, the surface-emitting OLEDs have superior electrical and optical characteristics and are readily fabricated at a high short-free yield.

### BRIEF DESCRIPTION OF THE DRAWINGS

FIG. 1 is a schematic diagram of a prior art organic surface-emitting device in which light is emitted through a thin MgAg cathode and an ITO outer layer;
FIG. 2 is a schematic diagram of an embodiment of the multilayer transparent cathode of the invention;
FIG. 3 shows the calculated transmittance of the multilayer cathode as a function of refractive index of the top layer;
FIG. 4 is a schematic diagram of an embodiment of the surface-emitting organic light-emitting diodes of the invention;
FIG. 5 shows electrical characteristics of the surface-emitting organic light-emitting diodes of the invention and the prior art;
FIG. 6 shows optical characteristics of the surface-emitting organic light-emitting diodes of the invention and the prior art;
FIG. 7 shows electrical characteristics of the surface-emitting organic light-emitting diodes of the invention. The properties of the devices with a different cathode structure (Ag/MgO, LiF/Al/MgO, and LiF/Al/Ag) are displayed in the figure for comparison; and
FIG. 8 shows optical characteristics of the surface-emitting organic light-emitting diodes of the invention. The properties of the devices with a different cathode structure (Ag/MgO, LiF/Al/MgO, and LiF/Al/Ag) are displayed in the figure for comparison.

The drawings are necessarily of a schematic nature, since the thicknesses of the individual layers are too thin, and thickness differences of the various elements too great to permit depiction to scale or to permit convenient proportionate scaling.

### DESCRIPTION OF THE PREFERRED EMBODIMENTS

Before describing the multilayer cathode and the surface-emitting OLEDs of the invention, one configuration of prior art surface-emitting OLED will be discussed.

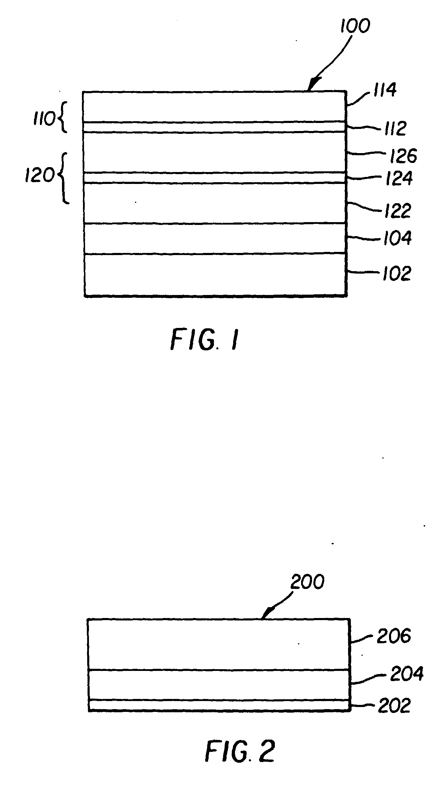

In FIG. 1, an organic light-emitting device 100 has a light-transmissive substrate 102 on which is disposed a light-transmissive anode 104. An organic light-emitting structure 120 is formed between the anode 104 and a cathode 110. The organic light-emitting structure 120 includes in sequence, an organic hole-transporting layer 122, an organic light-emitting layer 124, and an organic electron-transporting layer 126. The cathode structure 110 is comprised, in sequence, a thin MgAg layer 112 and a sputter-deposited ITO layer 114. When an electrical potential difference (not shown) is applied between the anode 104 and the cathode 110 such that the anode is at a more positive electrical potential with respect to the cathode, the cathode will inject electrons into the electron-transporting layer 126, and holes will be injected from the anode 104 into the hole-transporting layer 122. Hole-electron recombination occurs in the light-emitting layer 124, and energy is released as light, which is emitted through the light-transmissive anode 104 and substrate 102 as well as through the cathode 110. When an opaque substrate is used and a high-work function metal is serving as an anode, light is emitted only from the top cathode 110.

Turning now to FIG. 2, a multilayer transparent cathode 200 of the invention has, in order, an efficient electron injecting layer 202, a conductive and semi-transparent metal layer 204 over the electron injector, and a transparent layer 206 overlaid on the metal layer. The transparent layer has a reflective index equal to or greater than 1.2.

The electron injector 202 can be formed by depositing a metal layer having a work function of less than 4 eV on the organic electron-transporting layer. The electron injector metal is selected from the group consisting of alkali, alkaline earth, and rare earth metals. The alkali metal includes lithium, sodium, potassium, rubidium, or cesium. The alkaline earth metal includes magnesium, calcium, strontium, or barium. The rare earth metal includes cerium, neodymium, samarium, europium, gadolinium, or terbium. The thickness of the low-work-function metal layer is in the range of 0.2 to 2.0 nm.

The electron injector 202 can also be formed by depositing a 2-layer cathode on the electron-transporting layer. The 2-layer cathode is consisting of a thin inner layer of metal fluorides or oxides and a thin Al outer layer. The metal fluoride layers can be selected from alkali fluorides or alkaline earth fluorides. The metal oxide layers can be selected from alkali oxides or alkaline earth oxides. The alkali fluoride includes lithium fluoride, sodium fluoride, potassium fluoride, rubidium fluoride, or cesium fluoride; and the alkali oxide includes lithium oxide, sodium oxide, potassium oxide, rubidium oxide, or cesium oxide. The alkaline earth fluoride includes magnesium fluoride, calcium fluoride, strontium fluoride, or barium fluoride; and the alkaline earth oxide includes magnesium oxide, calcium oxide, strontium oxide, or barium oxide. The thickness of the fluoride or oxide layer is in the range of 0.2 to 2.0 nm, and the thickness of the Al layer is in the range of 0.2 to 4.0 nm.

The conductive and semi-transparent metal layer 204 can be selected from the group consisting of silver, gold, copper, and their alloys. These materials have low electric resistivities, thus substantially reducing the sheet resistance of cathodes. The thickness of the metal layer is in the range of 5-40 nm in order to form a continuous layer and offer a high transmittance to visible light.

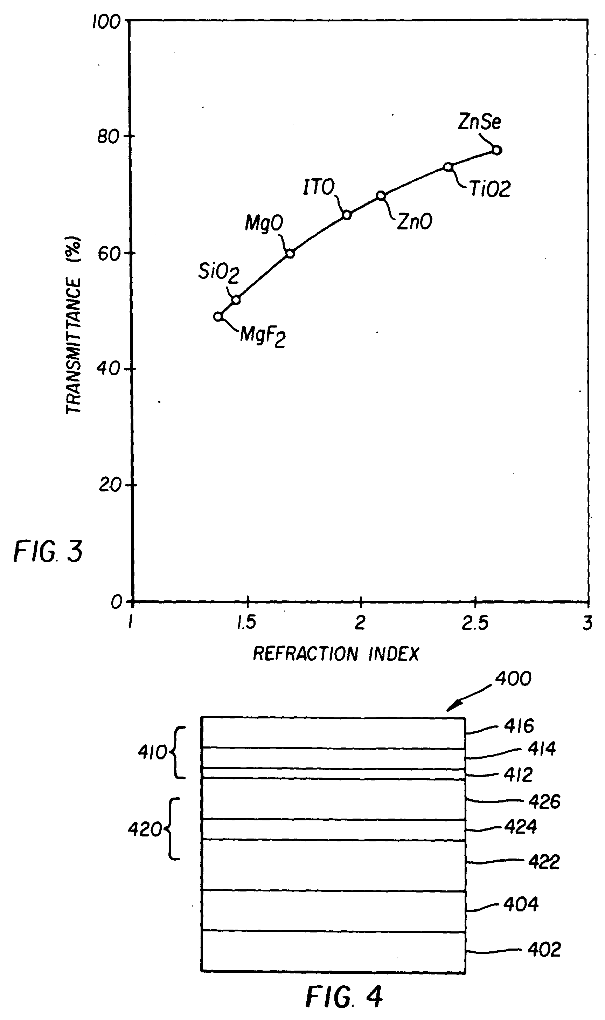

However, due to the high reflectance of the metal layers it is necessary to use a transparent overcoating layer 206 which has a refractive index equal to or greater than 1.2 to reduce reflectance and thus enhance light transmission through the cathode. Computer simulation was utilized to determine light transport through two structures. The first structure is consisting of an electron injecting layer and a 20-nm thick silver layer. The second structure is consisting of an electron injecting layer, a 20-nm thick silver layer, and a 55-nm magnesium oxide layer. In both cases, the electron injecting layer was made of a 0.3-nm LiF layer and a 0.6-nm Al layer. The optical properties of the two structures were calculated as a function of light wavelength. The first structure exhibits high reflectance and low transmittance. For instance, at 550 nm (corresponding to green light) the first structure approximately shows a reflectance of 60% and a transmittance of 30%. It is of interest to note that the addition of a magnesium oxide layer on the first structure substantially reduces light reflectance, and correspondingly increases the transmittance. For instance, at 550 nm the reflectance is reduced from 60% to 30%, and correspondingly the transmittance is increased from 30% to 60%. The improvement of light transmission can also be achieved when replacing the magnesium oxide layer by other materials with a relatively large reflective index. FIG. 3 shows how the transmittance varies with reflective index of the transparent layers. Therefore, any transparent materials with a reflective index equal to or greater than 1.2 can be selected to form the multilayer cathode. The materials can be selected from the group consisting of fluorides, oxide, and selenide. The fluoride includes lithium fluoride, magnesium fluoride, calcium fluoride, strontium fluoride, or barium fluoride. The oxide includes silicon oxide, magnesium oxide, indium oxide, tin oxide, zinc oxide, or zirconium oxide. The selenide includes zinc selenide or sulfur selenide.

Besides the listed inorganic transparent dielectric materials in FIG. 3, the materials can be organic materials as well, as long as the materials is transparent at the wavelength of interest and their refractive indices of the materials are equal to or greater than 1.2. For instance, α-napthylphenylbiphenyl diamine (NPB) and Tris-(8-hydroxyquinoline) aluminum (Alq) are suitable for this application.

In FIG. 4, a surface-emitting organic light-emitting diode 400 is illustrative which is formed in accordance with the present invention. Here the device 400 has a substrate 402, on which is disposed an anode 404. An organic light-emitting structure 420 is formed between the anode 404 and a cathode 410. The organic light-emitting structure 420 is comprised of, in sequence, an organic hole-transporting layer 422, an organic light-emitting layer 424, and an organic electron-transporting layer 426. The structure is distinct over the prior art of FIG. 1, as the cathode 410 is formed of a thin electron injecting layer 412, a semi-transparent metal layer 414, and a transparent layer 416 having a refractive index of 1.2 at least; and no sputtering is employed for film deposition. When an electrical potential difference (not shown) is applied between the anode 404 and the cathode 410 such that the anode is at a more positive electrical potential with respect to the cathode, the cathode 410 will inject electrons into the electron-transporting layer 426, and holes will be injected from the anode 404 into the hole-transporting layer 422. Hole-electron recombination occurs in the light-emitting layer 424, and energy is released as light, which is emitted through the light-transmissive anode 404 and substrate 402 as well as through the cathode 410. When an opaque substrate is used and a high-work function metal is serving as an anode, light is emitted only from the top cathode 410.

The substrate 402 are electrically insulated and can either be light transmissive or opaque. The light transmissive property is desirable for viewing the EL emission through both the bottom and the top surface. For applications where the EL emission is viewed through the top electrode, the transmissive characteristic of the support is immaterial, and therefore any appropriate substrate such as opaque semiconductor and ceramic wafers can be used.

Substrate 402 can be a transmissive substrate selected from the group of glass and plastic foil. It can be an opaque substrate, such as a single crystal semiconductor substrate selected from the group consisting of Si, Ge, GaAs, GaP, GaN, GaSb, InAs, InP, InSb, and AlₓGaₗ₋ₓAs, where x is from 0 to 1. Substrate 402 can be either undoped, lightly doped, or heavily doped. Substrate 402 is either bare or covered with a layer of dielectric material such as Si oxides or Si nitrides. In some applications, part of the semiconductor can be used as substrate 402 for electroluminescent devices, while the remainder of the semiconductor wafer can be processed to form drivers, switchers, or other electronic devices.

The anode 404 is formed of a conductive and transmissive layer. The light transparent property of the layer 404 is desirable for viewing the EL emission through the substrate and the top electrode. For applications where the EL emission is viewed through the top electrode, the transmissive characteristic of the layer 404 is immaterial, and therefore any appropriate materials such as metals or metal compounds having a work function greater than 4.2 eV can be used. The metal includes gold, iridium, molybdenum, palladium, or platinum. The conductive and transmissive layer can be selected from the group consisting of metal oxides, nitrides such as gallium nitride, selenides such as zinc selenide, and sulphides such as zinc sulphide. The suitable metal oxides include indium-tin oxide, aluminum- or indium-doped zinc oxide, tin oxide, magnesium-indium oxide, nickel-tungsten oxide, or cadmium-tin oxide.

The hole transporting layer of the organic EL device 422 contains at least one hole transporting aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monarylamine, diarylamine, triarylamine, or a polymeric arylamine. Exemplary monomeric triarylamines are illustrated by Klupfel and others US-A-3,180,730. Other suitable triarylamines substituted with vinyl or vinyl radicals and/or containing at least one active hydrogen containing group are disclosed by Brantley and others US-A-3,567,450 and US-A-3,658,520.

The luminescent layer 424 of the organic EL device includes a luminescent or fluorescent material, where electroluminescence is produced as a result of electron-hole pair recombination in this region. In the simplest construction, the luminescent layer comprises of a single component, that is a pure material with a high fluorescent efficiency. A well known material is tris (8-quinolinato) aluminum, (Alq), which produces excellent green electroluminescence. A preferred embodiment of the luminescent layer comprises a multi-component material consisting of a host material doped with one or more components of fluorescent dyes. Using this method, highly efficient EL devices can be constructed. Simultaneously, the color of the EL devices can be tuned by using fluorescent dyes of different emission wavelengths in a common host material. This dopant scheme has been described in considerable details for EL devices using Alq as the host material by Tang and others in commonly-assigned US-A-4,769,292.

Preferred materials for use in forming the electron transporting layer 426 of the organic EL devices of this invention are metal chelated oxinoid compounds, including chelates of oxine itself (also commonly referred to as 8-quinolinol or 8-hydroxyquinoline). Such compounds exhibit both high levels of performance and are readily fabricated in the form of thin layers.

The multilayer transparent cathode of the invention can have applications in other electroluminescent devices. One of the potential applications is the use of such structures in polymer light-emitting diodes.

### EXAMPLES

The following examples are presented for a further understanding of the invention. For purposes of brevity, the materials and the layers formed therefrom will be abbreviated as given below:
- ITO: : indium tin oxide (anode)
- NPB: : 4,4'-bis-[N-(1-naphthyl)-N-phenylamino]-bi-phenyl (hole-transporting layer)
- Alq: : tris (8-quinolinolato-N1, 08)-aluminum (electron-transporting layer; functioning here as a combined light-emitting layer and electron-transporting layer)
- MgAg: : magnesium: silver at a ratio of 10:1 by volume (cathode)
- MgO: : magnesium oxide (deposited on Ag to reduce light reflection)
- Ag: : silver (deposited on Al to reduce sheet resistance of cathodes)
- Al: : aluminum (deposited on LiF)
- LiF: : lithium fluoride (disposed over electron-transporting layer and combined with Al to form a electron injector))

### Preparation of an organic light-emitting structure:

An organic light-emitting structure was constructed in the following manner:
(a) a light-transmissive anode of ITO-coated glass was ultrasonicated in a commercial detergent, rinsed in deionized water, degreased in toluene vapor, and contacted by a strong oxidizing agent;
(b) a 75 nm thick NPB hole-transporting layer was deposited on the ITO-glass by conventional thermal vapor deposition; and
(c) a 75 nm thick Alq electron-transporting and light-emitting layer was deposited on the NPB layer by conventional thermal vapor deposition.

The above structure serves as a base configuration for each of the following examples, and is given in abbreviated form as ITO/NPB(75)/Alq(75).

### Example A

An organic light-emitting device was constructed as follows: a MgAg cathode was deposited on the Alq (75) layer of the base configuration by conventional thermal vapor deposition from two sources (Mg & Ag) to a thickness of about 200 nm, so as to produce a control device having an opaque top electrode.

### Example B

An organic light-emitting device was constructed as follows: a MgAg cathode was deposited on the Alq (75) layer of the base configuration by conventional thermal vapor deposition from two sources (Mg & Ag) to a thickness of about 10 nm, and then an ITO layer was overlaid on the thin MgAg buffer layer by radio frequency sputtering so as to provide a prior art device.

### Example C

An organic light-emitting device was constructed as follows: an Ag layer was deposited on the Al (q) layer of the base configuration by conventional thermal vapor deposition to a thickness of 20 nm, and then a MgO layer was deposited on the Ag layer to a thickness of 56 nm.

### Example D

An organic light-emitting device was constructed as follows: a LiF layer was deposited on the Al (q) layer of the base configuration by conventional thermal vapor deposition to a thickness of 0.3 nm, an Al layer with a thickness of 0.6 nm was deposited on the LiF layer, and then a MgO layer was deposited on the Al layer to a thickness of 56 nm.

### Example E

An organic light-emitting device was constructed as follows: a LiF layer was deposited on the Al (q) layer of the base configuration by conventional thermal vapor deposition to a thickness of 0.3 nm, an Al layer with a thickness of 0.6 nm was deposited on the LiF layer, and then an Ag layer was deposited on the LiF layer to a thickness of 20 nm.

### Example F

An organic light-emitting device was constructed as follows: a LiF layer was deposited on the Al (q) layer of the base configuration by conventional thermal vapor deposition to a thickness of 0.3 nm, an Al layer with a thickness of 0.6 nm was deposited on the LiF layer, a silver layer with a thickness of 20 nm was deposited on the LiF layer, and then a MgO layer was deposited on the silver layer to a thickness of 56 nm.

### Example G

An organic light-emitting device was constructed as follows: a LiF layer was deposited on the Al (q) layer of the base configuration by conventional thermal vapor deposition to a thickness of 0.3 nm, an Al layer with a thickness of 0.6 nm was deposited on the LiF layer, a silver layer with a thickness of 20 nm was deposited on the LiF layer, and then an Alq layer was deposited on the silver layer to a thickness of 100 nm.

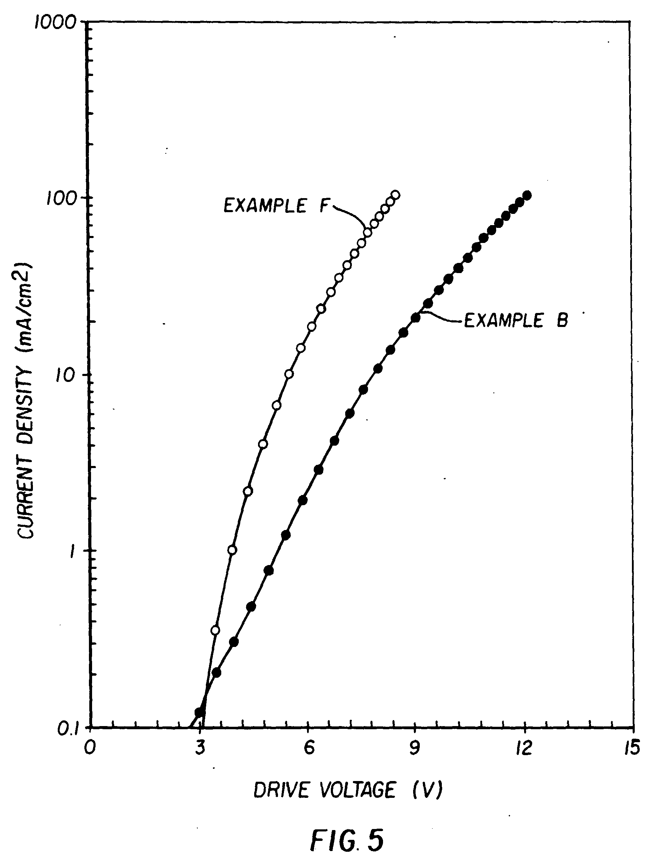

Electrical shorts were commonly observed in Example B, but the inter-electrode shorting was not observed in Examples F and G. The shorts were apparently caused by radiation damage during sputtering deposition of ITO. Each of the devices was tested by applying a drive voltage between the anode and cathode, such that the anode was positive with respect to the cathode. A current-drive voltage relationship and a current-luminance relationship were then determined, and the results are shown in FIGS 5-8.

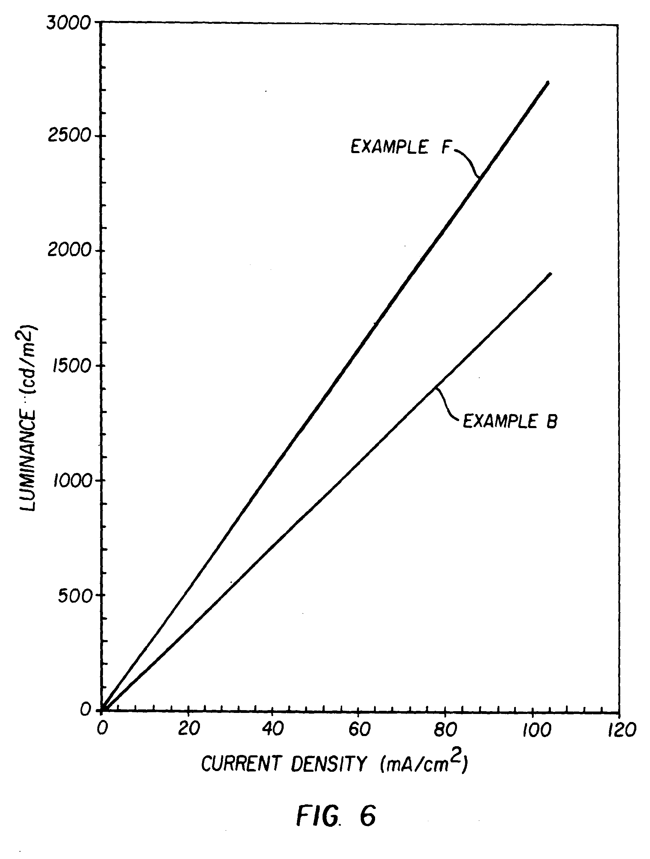

Viewing FIGS. 5 and 6, it is apparent that the surface-emitting OLED of the invention exhibits better electrical and optical characteristic than that the prior art. For instance, the voltage required to reach a current density of 100 mA/cm is 8.5 V and 12.2 V for the devices of Examples F and B, respectively. Furthermore, at 100 mA/cm² the luminance of the light emitted from the top electrode with a reflective coating layer on ITO-glass is 2640 cd/m² and 1840 cd/m² for the devices of Examples F and B, respectively.

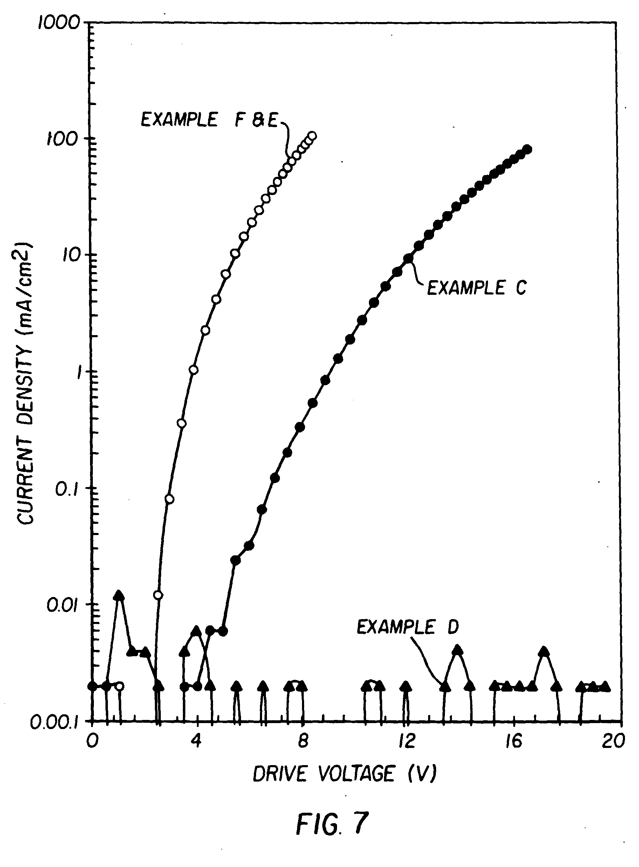

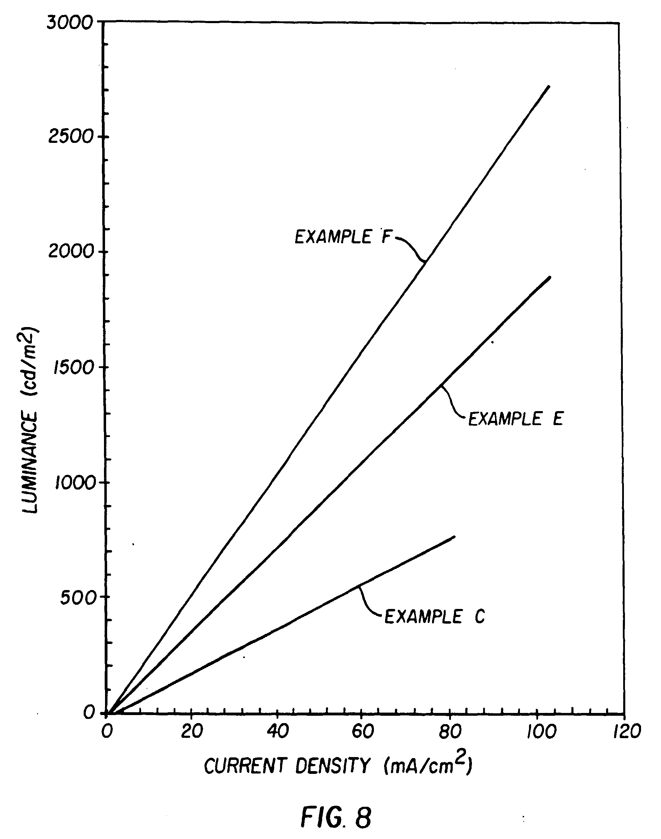

In FIGS. 7 and 8 the results obtained from Examples F, C, D and E are shown. It is clear that both electrical and optical characteristics of the surface-emitting OLED of the invention are much better than those measured on the devices with a different cathode configuration of Ag/MgO, LiF/Al/MgO, or LiF/Al/Ag. The device of Example C requires a much higher operating voltage than the device of Example F and exhibits a much lower electroluminescence efficiency due to the high-work-function material Ag used as an electron injector. For Example D, neither current nor luminance was detected at an operating voltage up to 20 V because the high resistive cathode blocked current transport. The current-voltage curve of Example E was identical to that of Example F, however, its electroluminescence efficiency was approximately 60-70% of the value measure on the device of Example F because of high reflectance of the cathode structure.

The results obtained from the device of Example G are very similar to those from the device of Example F. Thus it indicates that the transparent overcoating layer can be selected from both inorganic and organic materials.

Other features of the invention are included below.

The transparent cathode wherein the thickness of the low-work-function metal layer is in the range of 0.2 to 2.0 nm.

The transparent cathode wherein the electron injector is formed of a 2-layer structure.

The transparent cathode of the 2-layer structure is consisting of a thin metal fluoride layer and a thin Al outer layer.

The transparent cathode wherein the metal fluoride can be selected from the group consisting of alkali and alkaline earth fluorides.

The transparent cathode wherein the alkali fluoride includes lithium fluoride, sodium fluoride, potassium fluoride, rubidium fluoride, or cesium fluoride.

The transparent cathode wherein the alkaline earth fluoride includes magnesium fluoride, calcium fluoride, strontium fluoride, or barium fluoride.

The transparent cathode wherein the thickness of the fluoride layer is in the range of 0.2 to 2.0 nm, and the thickness of the Al layer is in the range of 0.2 to 4.0 nm.

The transparent cathode wherein the 2-layer structure is consisting of a thin metal oxide layer and a thin Al outer layer.

The transparent cathode wherein the metal oxide is selected from the group consisting of alkali and alkaline earth oxides.

The transparent cathode wherein the alkali oxide includes lithium oxide, sodium oxide, potassium oxide, rubidium oxide, or cesium oxide.

The transparent cathode wherein the alkaline earth oxide includes magnesium oxide, calcium oxide, strontium oxide, or barium oxide.

The transparent cathode wherein the thickness of the oxide layer is in the range of 0.2 to 2.0 nm, and the thickness of the Al layer is in the range of 0.2 to 4.0 nm.

The transparent cathode wherein the metal layer is conductive and semi-transparent.

The transparent cathode wherein the metal layer is selected from the group consisting of silver, gold, copper, and their alloys.

The transparent cathode wherein the thickness of the metal layer is in the range of 5-40 nm.

The transparent cathode wherein the transparent layer is selected from the group consisting of inorganic and organic materials.

The transparent cathode wherein the inorganic material is selected from the group consisting of fluoride, oxide, and selenide.

The transparent cathode wherein the fluoride includes lithium fluoride, magnesium fluoride, calcium fluoride, strontium fluoride, or barium fluoride.

The transparent cathode wherein the oxide includes silicon oxide, magnesium oxide, indium oxide, tin oxide, zinc oxide, or zirconium oxide.

The transparent cathode wherein the selenide includes zinc selenide or sulfur selenide.

The transparent cathode wherein the organic material includes napthylphenylbiphenyl diamine (NPB) and Tris-(8-hydroxyquinoline) aluminum (Alq).

The surface-emitting organic light-emitting diode wherein the substrate is electrically insulated and is light transmissive or opaque.

The surface-emitting organic light-emitting diode wherein the light transmissive substrate is selected from the group consisting of glass and plastic foil.

The surface-emitting organic light-emitting diode wherein the light opaque substrate can be a single crystal semiconductor substrate selected from the group consisting of Si, Ge, GaAs, GaP, GaN, GaSb, InAs, InP, InSb, and AlₓGaₗ₋ₓAs, where x is from 0 to 1.

The surface-emitting organic light-emitting diode wherein the anode is a conductive and transmissive layer formed from metal oxides.

The surface-emitting organic light-emitting diode wherein the oxide includes indium-tin oxide, aluminum- or indium-doped zinc oxide, tin oxide, magnesium-indium oxide, nickel-tungsten oxide, or cadmium-tin oxide.

The surface-emitting organic light-emitting diode wherein the anode is a conductive and opaque layer formed from metal or metal alloys.

The surface-emitting organic light-emitting diode wherein the metal and metal alloy include nickel, gold, iridium, molybdenum, palladium, or platinum.

The surface-emitting organic light-emitting diode wherein the organic hole-transporting layer is formed of a material including hole-transporting aromatic tertiary amine molecules.

The surface-emitting organic light-emitting diode wherein the organic light-emitting layer is formed of a light-emitting host material consisting of a metal chelated oxinoid compound.

The surface-emitting organic light-emitting diode wherein the organic light-emitting layer further includes at least one dye which emits light when dispersed in the light-emitting host material.

The surface-emitting organic light-emitting diode wherein the electron-transporting layer is formed of a material consisting of a metal chelated oxinoid compound.

## Claims

1. A transparent cathode comprising:
(a) an electron injector;
(b) a metal layer over the injector; and
(c) a transparent layer deposited over the metal layer and having a refractive index equal to or greater than 1.2.

2. The transparent cathode of claim 1 wherein the electron injector is formed of a metal having a work function of less than 4 eV.

3. The transparent cathode of claim 2 wherein the electron injector metal is selected from the group consisting of alkali, alkaline earth, and rare earth metals.

4. The transparent cathode of claim 3 wherein the alkali metal includes lithium, sodium, potassium, rubidium, or cesium.

5. The transparent cathode of claim 3 wherein the alkaline earth metal includes magnesium, calcium, strontium, or barium.

6. The transparent cathode of claim 3 wherein the rare earth metal includes cerium, neodymium, samarium, europium, gadolinium, or terbium.

7. A surface-emitting organic light-emitting diode comprising:
(a) a substrate formed of an electrically insulating material;
(b) a conductive anode mounted over the substrate;
(c) an organic light-emitting structure formed over the anode layer; and
(d) a transparent cathode formed over the organic light-emitting structure and including:
(i) an electron injector,
(ii) a metal layer over the electron injector; and
(iii) a transparent layer overlaid on the metal layer and having a reflective index equal to or greater than 1.2.

8. The surface-emitting organic light-emitting diode of claim 7 wherein the organic light-emitting structure includes:
(a) an organic hole-transporting layer formed over the anode layer;
(b) an organic light-emitting layer formed over the hole-transporting layer; and
(c) an organic electron-transporting layer formed over the light-emitting layer.
